# EUROPEAN PATENT APPLICATION

(11) **EP 4 852 665 A1**
(43) Date of publication of application: **09.12.2026**
(21) Application number: 26154461.3
(22) Date of filing: 27.01.2026
(51) Int. Cl.: H10F 30/223, H10F 71/00, H10F 77/14, H10F 77/30, H10F 77/70

(54) **PHOTODIODE AND MANUFACTURING METHOD THEREOF**

(30) Priority: 04.06.2025 TW 114120866
(71) Applicant: Taiwan-Asia Semiconductor Corporation, Hsinchu City 30078 (TW)
(72) Inventor: Wu, Chia-Ying, 30078 Hsinchu City (TW); Chen, Chih-Hung, 30078 Hsinchu City (TW); Yang, Yun-Jie, 30078 Hsinchu City (TW)
(74) Representative: Michalski Hüttermann & Partner mbB

(57) **Abstract**

A photodiode and a manufacturing method thereof are provided. The photodiode has a non-rectangular polygonal shape and comprises a substrate, an epitaxial composite layer, and an optical film. The substrate has the non-rectangular polygonal shape, and there are etching marks existed on a sidewall surface of the polygonal shape. The epitaxial composite layer is disposed on the substrate, and the optical film is disposed on the epitaxial composite layer.

## Description

### CROSS-REFERENCES TO RELATED APPLICATIONS

This application claims the benefit of priority to Taiwanese Patent Application No. 114120866 filed on June 4, 2025, which is hereby incorporated by reference in its entirety.

### BACKGROUND OF THE INVENTION

### Field of the Invention

The present invention relates to a photodiode and a manufacturing method thereof, and more particularly to a photodiode with high sensing linearity and a manufacturing method thereof.

### Descriptions of the Related Art

A photodiode is an electronic device that converts an external light signal into an electrical signal. The absorption of external light is its core function, as this allows it to detect an external light signal and convert it into a measurable current. This conversion is crucial for various applications such as optical communication, optical measurement, and imaging generation.

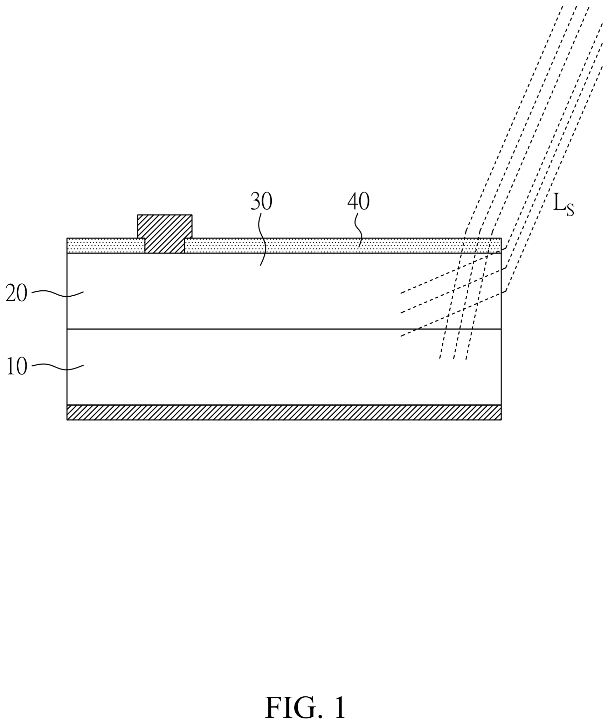

As shown in FIG. 1, the main components of a conventional photodiode include a substrate 10, an intrinsic layer 20, a P-type doped layer 30, and an optical film 40. When the photodiode absorbs external light, the semiconductor epitaxial material of the intrinsic layer 20 inside the diode absorbs the light. Upon absorption, the energy of the photons can cause electrons in the valence band of the semiconductor material to jump to the conduction band, for generating electron-hole pairs. These photogenerated carriers are separated by the built-in electric field of the photodiode, thereby generating a current.

However, in practical applications, external light can easily enter the interior of the device through exposed sidewalls of the device, causing internal interference that affects the linearity of the light response of the photosensitive device and the calculation errors in subsequent related device applications. As shown in FIG. 1, when external light L_{S} penetrates the exposed sidewall of the device, it is refracted into the device due to the refractive index of the silicon substrate being 3.4, which is greater than the refractive index of air, which is 1. This affects the linearity of the photodiode's sensing. To overcome the above problems, there is an urgent need in the industry for an innovative photodiode architecture to improve the problem of insufficient light response linearity caused by external light penetrating the device sidewalls.

### SUMMARY OF THE INVENTION

The main objective of the present invention is to provide an innovative photodiode and a manufacturing method thereof. Compared to conventional photoelectric devices, the photodiode of the present invention adds a wet etching process specifically to the photodiode after the plasma or laser cutting process to modify the sidewalls of the photodiode. This is intended to improve the problem of insufficient light response linearity at the edges of the aforementioned device, thereby reducing the calculation errors in subsequent applications of the photosensitive device.

To achieve the above objective, the present invention provides a photodiode. The photodiode has a non-rectangular polygonal shape and comprises a substrate, an epitaxial composite layer, and an optical film. The substrate has the non-rectangular polygonal shape, and a sidewall surface of the polygonal shape has an etching mark. The epitaxial composite layer is disposed on the substrate, and the optical film is disposed on the epitaxial composite layer.

In one embodiment of the photodiode of the present invention, the etching mark is a step difference between the substrate and the epitaxial composite layer.

In one embodiment of the photodiode of the present invention, the etching mark is a microscopic etching texture on the sidewall surface of the epitaxial composite layer.

In one embodiment of the photodiode of the present invention, the epitaxial composite layer has an intrinsic layer and a P-type doped layer. The intrinsic layer is disposed on the substrate, and the optical film is disposed on the P-type doped layer.

In one embodiment of the photodiode of the present invention, the optical film has a band pass filter layer covering the P-type doped layer, which selectively allows light of a specific wavelength to pass through and be received by the intrinsic layer.

In one embodiment of the photodiode of the present invention, the optical film further has an anti-reflective coating (ARC) layer covering the band pass filter layer to increase the amount of light of the specific wavelength entering the epitaxial composite layer and reduce light reflection.

To achieve the above objective, the present invention provides a manufacturing method for a photodiode, comprising the following steps: cutting a wafer to form a plurality of photodiode dies, where each photodiode die includes a substrate and an epitaxial composite layer disposed on the substrate, and each photodiode die has a non-rectangular polygonal shape; and wet etching the photodiode dies to form an etching mark on a sidewall surface of the polygonal shape of each photodiode die.

In one embodiment of the manufacturing method for the photodiode of the present invention, the step of wet etching the photodiode dies is isotropic wet etching.

In one embodiment of the manufacturing method for the photodiode of the present invention, the step of isotropic wet etching is to immerse the photodiode dies in an HNA etching solution of nitric acid (HNO₃), hydrofluoric acid (HF), and acetic acid (CH₃COOH).

In one embodiment of the manufacturing method for the photodiode of the present invention, the step of isotropic wet etching is to form a step difference between the substrate and the epitaxial composite layer.

In one embodiment of the manufacturing method for the photodiode of the present invention, the step of wet etching the photodiode dies is anisotropic wet etching.

In another embodiment of the manufacturing method for the photodiode of the present invention, the step of anisotropic wet etching is to immerse the photodiode dies in an etching solution of one of potassium hydroxide (KOH), sodium hydroxide (NaOH), ethylenediamine pyrocatechol (EDP), hydrazine (N₂H₄), or tetramethylammonium hydroxide (TMAH).

In another embodiment of the manufacturing method for the photodiode of the present invention, the step of anisotropic wet etching is to form a microscopic etching texture on the sidewall surface of the epitaxial composite layer.

In another embodiment of the manufacturing method for the photodiode of the present invention, the step of cutting a wafer is to cut the wafer using either plasma or a laser.

After referring to the drawings and the embodiments described subsequently, those skilled in the art will understand the other objectives of the present invention, as well as the technical means and embodiments of the present invention.

### BRIEF DESCRIPTION OF THE DRAWINGS

FIG. 1 shows a schematic diagram of light concentration after external light enters a conventional photodiode structure;
FIG. 2 shows a schematic diagram of a photodiode in one embodiment of the present invention;
FIG. 3 shows an SEM photograph of the square dashed area 1 in FIG. 2;
FIG. 4 shows an SEM photograph of the substrate sidewall of a photodiode without wet etching treatment in part (A) and an SEM photograph of the square dashed area 2 in FIG. 2 in part (B);
FIG. 5 shows a comparison schematic diagram of the linearity differences of the photodiode of the present invention at different etching rates under different light-receiving wavelength conditions;
FIG. 6 shows a process step flowchart for a photodiode in one embodiment of the present invention; and
FIG. 7 shows a process step flowchart for a photodiode in another embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

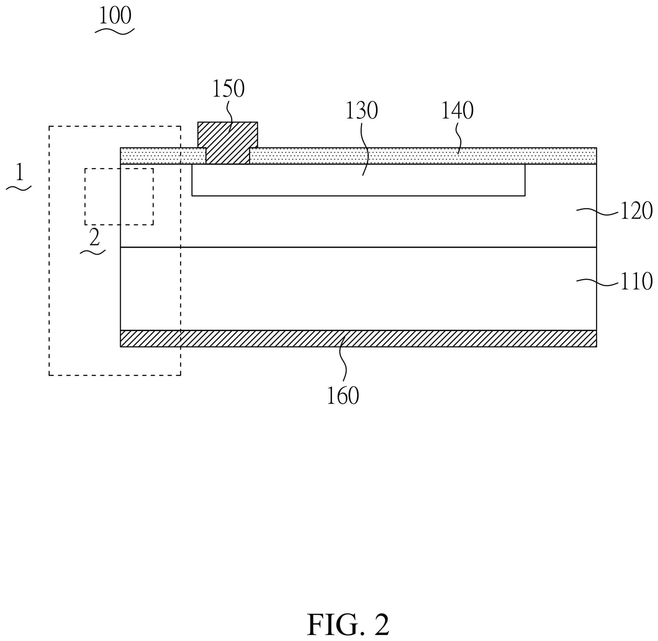

Please refer to FIG. 2, which shows a schematic diagram of a photodiode in one embodiment of the present invention. The photodiode 100 in this embodiment comprises a substrate 110, an epitaxial composite layer composed of an intrinsic layer 120 and a P-type doped layer 130, an optical film 140, an upper electrode 150, and a lower electrode 160. The substrate 110 is a conductive substrate, such as an N-type heavily doped silicon wafer, which can specifically be a silicon wafer with antimony (Sb) doping, with a doping concentration of approximately 10¹⁸ to 10¹⁹ cm⁻³. It should be noted that, to meet the demand for miniaturization and high density of optoelectronic modules in wearable devices, the photodiode of the present invention has a non-rectangular polygonal shape, such as a hexagonal or trapezoidal shape, to increase the overall light-receiving area of the optoelectronic module of the wearable device.

The intrinsic layer 120 in the epitaxial composite layer is a lightly doped epitaxial layer disposed on the substrate 110. For example, but not limited to, it is an N-type lightly doped silicon epitaxial layer, with phosphorus (P) as the doping element and a doping concentration of 10¹² to 10¹³ cm⁻³, used to receive light of a specific wavelength and correspondingly generate an electrical signal. The thickness of the intrinsic layer 120 is usually precisely designed according to the wavelength of light and application requirements. Controlling the thickness of the intrinsic layer 120 is crucial for photoelectric conversion efficiency. In this invention, for example, the thickness of the intrinsic layer 120 is approximately 50 to 70 micrometers (µm), but it is not limited thereto. In addition, as shown in FIG. 2, the P-type doped layer 130 in the epitaxial composite layer is disposed on a central region of the intrinsic layer 120. The P-type doped layer 130 can be a P-type heavily doped silicon epitaxial layer, such as, but not limited to, a silicon epitaxial layer with boron (B) as the doping element and a doping concentration of 10¹⁹ to 10¹⁰ cm⁻³.

Please continue to refer to FIG. 2. The optical film 140 is typically a band pass filter layer covering the P-type doped layer 130, which selectively allows light of a specific wavelength to pass through and be received by the intrinsic layer 120, and blocks unnecessary light of other wavelengths, such as visible light or infrared light. The optical film 140 is usually composed of multiple layers of dielectric materials, which are typically alternating layers of high and low refractive index materials, such as silicon dioxide (SiO₂), titanium dioxide

(TiO₂), or silicon nitride (Si₃N₄). In a preferred embodiment, the optical film 140 further includes an anti-reflective coating (ARC) layer formed on the band pass filter layer to enhance the transmittance of light in a specific wavelength band, improve photon utilization, and minimize the reflection loss of incident light, thereby increasing the photoelectric conversion efficiency of the device. On the other hand, the upper electrode 150 is the anode electrode, disposed on the P-type doped layer 130 and electrically connected thereto. The lower electrode 160 is the cathode electrode, disposed on the back side of the substrate 110 and electrically connected thereto. The upper electrode 150 and the lower electrode 160 can be, but are not limited to, aluminum metal.

As mentioned earlier, in order for the photodiode of the present invention to have a non-rectangular polygonal shape, after completing the aforementioned epitaxial and metal wiring processes on the wafer, it is not possible to cut the wafer with a conventional mechanical cutting blade. Instead, plasma or laser cutting must be used to cut the wafer to form non-rectangular polygonal dies such as hexagonal or trapezoidal shapes. However, after cutting the wafer with plasma or a laser, the photodiode will have the problem of poor light response linearity at the edges of the device, as previously described. Therefore, the present invention specifically modifies the sidewalls of the photodiode 100, including the sidewall of the substrate 110 and the sidewall of the intrinsic layer 120 in the epitaxial composite layer, to improve the light response linearity of the entire device's edge region.

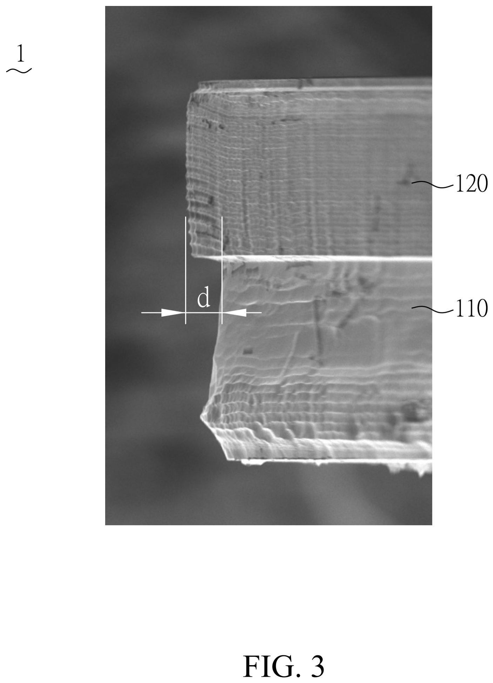

Specifically, after the wafer is cut by plasma or a laser, the active area on the front side of the photodiode is protected, and then the entire die is subjected to a wet etching process to form an etching mark on the sidewall surface of the polygonal shape, thereby changing the sidewall structure of the device die. Since wet etching has two etching modes, isotropic and anisotropic, they will be described separately below. First, for isotropic wet etching, an HNA etching solution of nitric acid (HNO₃), hydrofluoric acid (HF), and acetic acid (CH₃COOH) is provided to immerse all the photodiode dies. After a specific time and temperature adjustment, the sidewalls of the photodiode dies will be modified. Specifically, the etching mark formed on the sidewall surface of the polygonal die, as shown in the square dashed area 1 in FIG. 2, will be a step difference at the interface between the sidewalls of the substrate 110 and the intrinsic layer 120 of the epitaxial composite layer. As shown in FIG. 3, it displays a scanning electron microscope (SEM) enlarged photograph of a step difference d between the substrate 110 and the intrinsic layer 120. The reason for this step difference d is mainly because isotropic wet etching has different etching rate selectivity for different materials of the substrate and the epitaxial composite layer, and isotropic etching has no etching saturation point. This causes a delamination phenomenon with a step difference between the substrate and the epitaxial layer. For isotropic wet etching, the etching rate can be further adjusted according to the etching time and etching concentration.

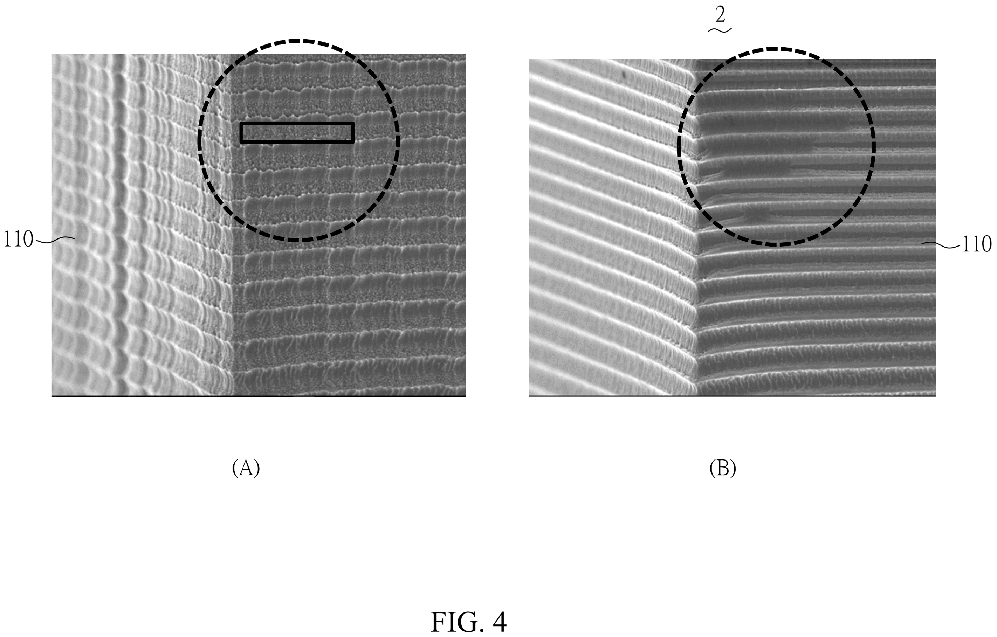

On the other hand, for anisotropic wet etching used as a photodiode sidewall modification process, an etching solution of one of potassium hydroxide (KOH), sodium hydroxide (NaOH), ethylenediamine pyrocatechol (EDP), hydrazine (N₂H₄), or tetramethylammonium hydroxide (TMAH) is provided to immerse all the photodiode dies. After a specific time and temperature adjustment, the sidewalls of the photodiode dies will be modified. Please refer to the square dashed area 2 in FIG. 2 and FIG. 4. The square dashed area 2 in FIG. 2 is the sidewall of the intrinsic layer 120 in the epitaxial composite layer, and FIG. 4 is an SEM enlarged photograph of the square dashed area 2 in FIG. 2. Unlike the aforementioned isotropic wet etching, anisotropic wet etching has an etching saturation point. Therefore, the etching mark formed on the polygonal sidewall surface of the photodiode after the anisotropic wet etching treatment is not a step difference as shown in FIG. 3. Instead, a continuous surface is formed between the substrate and the epitaxial layer. When the substrate sidewall is observed with a high-magnification SEM, anisotropic wet etching leaves a dark, irregular-shaped microscopic etching texture on the sidewall of the intrinsic layer 120 of the epitaxial composite layer, as shown in part (B) on the right side of FIG. 4.

To clearly illustrate the difference in photodiode sidewall modification from anisotropic wet etching, the present invention specifically shows the difference before and after modification by comparing the process without wet etching and with anisotropic wet etching. The SEM photograph in part (A) on the left side of FIG. 4 represents the sidewall of the intrinsic layer 120 of a photodiode that has not been subjected to wet etching. On the other hand, the SEM photograph in part (B) on the right side of FIG. 4 represents the sidewall of the intrinsic epitaxial layer of the photodiode in the square dashed area 2 of FIG. 2 after anisotropic wet etching. It is clear that in part (A) on the left side of FIG. 4, there are multiple stacked bumps as marked in the long solid-line area on the sidewall that has not been wet-etched away. On the other hand, in part (B) on the right side of FIG. 4, the stacked bumps on the sidewall after anisotropic wet etching have disappeared, leaving only a dark, irregular-shaped microscopic etching texture as shown in the circular dashed area. This microscopic etching texture is essentially a relatively smooth surface as compared with the texture of part (A). The reason for its formation is that the anisotropic wet etching process on the substrate sidewall surface not only removes the exposed bumps on the sidewall but also increases the smoothness of the sidewall surface, leaving behind the dark, irregular microscopic etching texture. This microscopic etching texture is the etching mark formed on the die's sidewall surface by anisotropic wet etching.

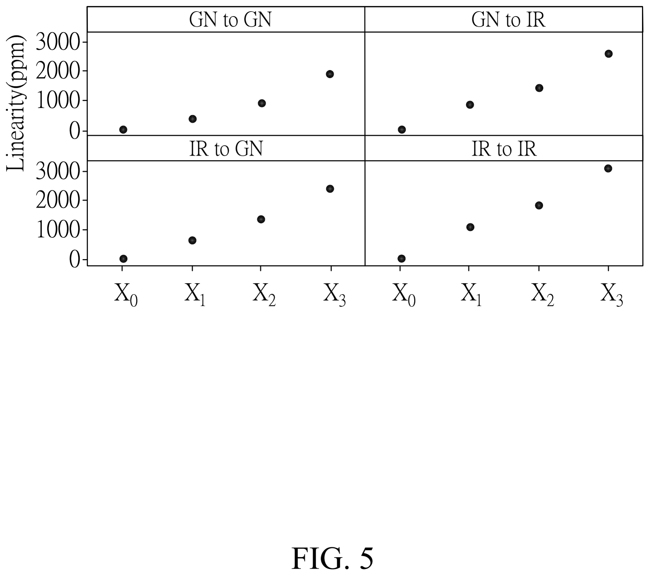

After the photodiode dies are subjected to isotropic or anisotropic wet etching, they are rinsed and dried, and then linearity testing is performed. As shown in FIG. 5, it shows the linearity performance of a photodiode device after plasma cutting and wet etching treatment under different light wavelength bands and different wet etching rates. GN to GN represents the linearity comparison of green light provided by the light-emitting diode with the photodiode receiving in the green light band; IR to GN represents the linearity comparison of infrared light provided by the light-emitting diode with the photodiode receiving in the green light band; GN to IR represents the linearity comparison of green light provided by the light-emitting diode with the photodiode receiving in the infrared light band; IR to IR represents the linearity comparison of infrared light provided by the light-emitting diode with the photodiode receiving in the infrared light band. The linearity on the vertical axis represents the signal-to-noise ratio (SNR) between the signal and noise, in PPM. The horizontal axis represents four etching conditions: X₀ represents the etching condition without wet etching, X₁ represents a low-rate wet etching condition, X₂ represents a medium-rate wet etching condition, and X₃ represents a high-rate wet etching condition. FIG. 5 shows that if the linearity of etching condition X₀ (without wet etching) is taken as the baseline, the higher the three etching rates, the more the linearity of the photodiode's light response can be improved. In other words, in actual etching operations, different wet etching modification processes can be performed at different etching rates to adjust the photodiode's linearity performance to meet the device's linearity specifications, depending on the linearity requirements.

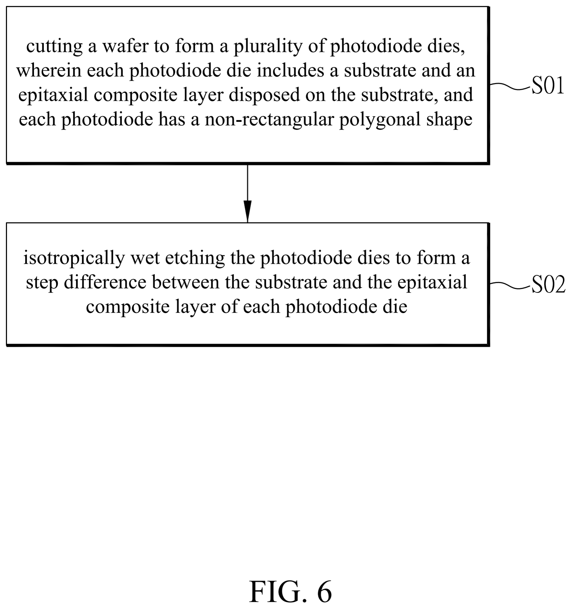

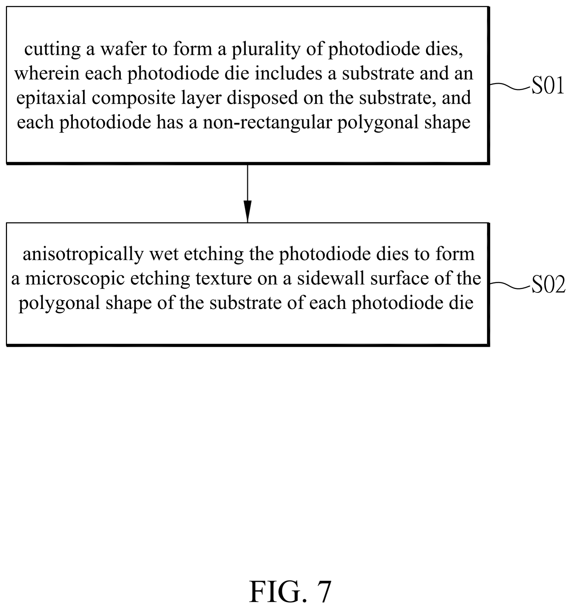

Please refer to FIG. 6, which shows a schematic diagram of the process steps for a photodiode of the present invention treated with isotropic wet etching. First, in step S01, a wafer is cut to form a plurality of photodiode dies. Each photodiode die includes a substrate and an epitaxial composite layer disposed on the substrate, and each photodiode has a non-rectangular polygonal shape. Next, in step S02, the photodiode dies are isotropically wet etched to form a step difference between the substrate and the epitaxial composite layer of each photodiode die. Similarly, please refer to FIG. 7, which shows a schematic diagram of the process steps for a photodiode of the present invention treated with anisotropic wet etching. First, in step S01, a wafer is cut to form a plurality of photodiode dies. Each photodiode die includes a substrate and an epitaxial composite layer disposed on the substrate, and each photodiode has a non-rectangular polygonal shape. Next, in step S02, the photodiode dies are anisotropically wet etched to form a microscopic etching texture on a sidewall surface of the polygonal shape of the substrate of each photodiode die. The descriptions of the related devices can refer to the foregoing content and will not be repeated here.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A photodiode, comprising:
a substrate having a non-rectangular polygonal shape, wherein a sidewall surface of the polygonal shape has an etching mark;
an epitaxial composite layer, disposed on the substrate; and
an optical film, disposed on the epitaxial composite layer.

2. The photodiode of the previous claim, wherein the etching mark is a step difference between the substrate and the epitaxial composite layer.

3. The photodiode of any of the previous claims, wherein the etching mark is a microscopic etching texture on a sidewall surface of the epitaxial composite layer.

4. The photodiode of any of the previous claims, wherein the epitaxial composite layer has an intrinsic layer and a P-type doped layer, the intrinsic layer is disposed on the substrate, and the optical film is disposed on the P-type doped layer.

5. The photodiode of the previous claim, wherein the optical film has a band pass filter layer covering the P-type doped layer, for selectively allowing light of a specific wavelength to pass through and be received by the intrinsic layer.

6. The photodiode of the previous claim, wherein the optical film further has an anti-reflective coating (ARC) layer covering the band pass filter layer, used to increase the amount of the light of the specific wavelength entering the epitaxial composite layer and reduce the reflection of the light.

7. A manufacturing method for a photodiode, comprising:
cutting a wafer to form a plurality of photodiode dies, wherein each of the photodiode dies includes a substrate and an epitaxial composite layer disposed on the substrate, and each of the photodiode dies has a non-rectangular polygonal shape; and
wet etching the photodiode dies to form an etching mark on a sidewall surface of the polygonal shape of each of the photodiode dies.

8. The manufacturing method for a photodiode of the previous claim, wherein the step of wet etching the photodiode dies is isotropic wet etching.

9. The manufacturing method for a photodiode of the previous claim, wherein the step of isotropic wet etching is to immerse the photodiode dies in an HNA etching solution of nitric acid (HNO₃), hydrofluoric acid (HF), and acetic acid (CH₃COOH).

10. The manufacturing method for a photodiode of claim 8, wherein the step of isotropic wet etching is to form a step difference between the substrate and the epitaxial composite layer.

11. The manufacturing method for a photodiode of any of the previous four claims, wherein the step of wet etching the photodiode dies is anisotropic wet etching.

12. The manufacturing method for a photodiode of the previous claim, wherein the step of anisotropic wet etching is to immerse the photodiode dies in an etching solution of one of potassium hydroxide (KOH), sodium hydroxide (NaOH), ethylenediamine pyrocatechol (EDP), hydrazine (N₂H₄), or tetramethylammonium hydroxide (TMAH).

13. The manufacturing method for a photodiode of claim 11, wherein the step of anisotropic wet etching is to form a microscopic etching texture on a sidewall surface of the epitaxial composite layer.

14. The manufacturing method for a photodiode of any of the previous claims 7 to 13, wherein the step of cutting a wafer is to cut the wafer using either plasma or a laser.
